(19) Europäisches Patentamt

European Patent Office

Office européen des brevets

(11) EP 1 079 434 A2

## (12) EUROPEAN PATENT APPLICATION

(43) Date of publication:
28.02.2001 Bulletin 2001/09

(51) Int. Cl.7: H01L 23/50, H01L 23/66

(21) Application number: 00118113.0

(22) Date of filing: 25.08.2000

(84) Designated Contracting States:
AT BE CH CY DE DK ES FI FR GB GR IE IT LI LU
MC NL PT SE
Designated Extension States:
AL LT LV MK RO SI

(30) Priority: 27.08.1999 JP 24220699

(71) Applicant:
KABUSHIKI KAISHA TOSHIBA
Kawasaki-shi, Kanagawa-ken 210-8572 (JP)

(72) Inventor:
Emoto, Takao,
Kabushiki Kaisha Toshiba
Minato-ku, Tokyo 105-8001 (JP)

(74) Representative: HOFFMANN - EITLE
Patent- und Rechtsanwälte
Arabellastrasse 4
81925 München (DE)

### (54) Power device packaging structure

(57)    A vertical-type MOSFET is formed within a semiconductor chip (1). The rear surface of the semiconductor chip (1) serves as a drain of the vertical-type MOSFET, and is fixed to a frame heat radiating portion (2-1). A source electrode (5) and a gate electrode (6) are formed on a main surface of the semiconductor chip (1). The source electrode (5) is connected to external electrodes (2-2-1, 2-2-2) via bonding wires (3a, 3c). The gate electrode (6) is connected to an external electrode (2-3) via bonding wires (3b). Further, an input voltage is applied between the external electrode (2-3) and the external electrode (2-2-2), and an output current is allowed to flow between the external electrode (2-1) and the external electrode (2-2-1).

FIG. 3

EP 1 079 434 A2

## Description

The present invention relates to a packaging structure of a power device, and more specifically to a type that is used in an element having a high input impedance, such as MOSFET or IGBT.

Generally, a small-size or middle-size power device having an On-state current of 100 [A] or less and a power of 300 [W] or less, has a packaging structure in which semiconductor chips are sealed with resin.

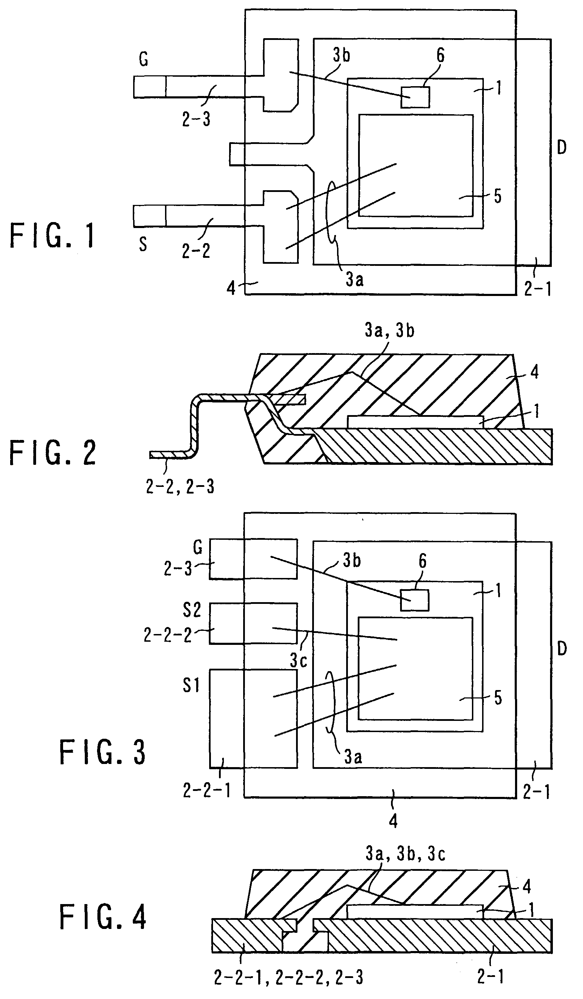

An example of the packaging structure of a power MOSFET is shown in FIGS. 1 and 2. As shown in these figures, A MOSFET (switching element) is formed on a semiconductor chip 1, and a rear surface of the semiconductor chip 1 becomes to serve as a drain of the MOSFET. The rear surface of the semiconductor chip 1 is fixed to a frame heat radiating section 2-1 by soldering or conductive resin.

The frame heat radiating portion 2-1 has a function of radiating the heat generated within the semiconductor chip 1 to the outside of the package, and further functions as an external terminal (D) of the drain of the MOSFET.

In the meantime, a source electrode 5 and a gate electrode 6 of the MOSFET are formed on the main surface of the semiconductor chip 1. The source electrode 5 is connected to an external terminal (S)2-2 of the source of the MOSFET by a bonding wire 3a. The gate electrode 6 is connected to an external terminal (G)2-3 of the source of the MOSFET by a bonding wire 3b. The bonding wires 3a and 3b are made of a metal material such as aluminum or gold.

The semiconductor chip 1 and its peripheral members are covered with the resin 4 and portions of the external terminals (G, D and S) are exposed from the resin 4.

It should be noted that the locations of the external terminals (G, D and S) may be changed in various ways. For example, in FIGS. 1 and 2, the position of the external terminal (G) of the gate and that of the external terminal (S) of the source may be switched, or the external terminal (D) of the drain may be provided between the external terminal (G) of the gate and the external terminal (S) of the source so that all the terminals are aligned in one line.

At present, a power device is used mainly as a switching element which constitutes a DC-DC converter, motor controlling circuit, power source circuit or the like. The structure of the power device is mainly of a MOS type having a high impedance. This is because the driving circuit which uses a MOS-type power device has characteristics that the chip size can be reduced, as compared to the driving circuit which uses a bi-polar-type power device.

The output efficiency of the power device (switching element) is determined mainly by the on-state power dissipation and turn-on (switching) power dissipation and turn-off (switching) power dissipation. Therefore, conventionally, the objects of the development of power devices are to reduce the On-resistance and to increase the switching speed (that is, to enhance the high-frequency operation property).

The characteristics of the power MOSFETs and the use conditions have been significantly enhanced over past several years. For example, with regard to the On-resistance, it has been reduced to 1/10 to 1/15 as compared to that of the MOSFETs of several years ago, and the operation frequency has been increased from 50 [kHz] to 100 [kHz].

However, if the operation frequency is enhanced close to 100 [kHz] or higher, a new drawback such as that the effect of characteristics of the MOSFET cannot longer be improved has occurred. This drawback is considered to be based on the fact that the impedance has a relationship of $1/z = 1/r + 1/2\pi fL$ and $Z_L = 2\pi fL$ , and therefore as the operation frequency becomes high as described above, the On-resistance of the MOSFET is increased.

Further, in recent years, for the mount of electronic parts on a board, the surface mount technology is applied in accordance with the demands of downsizing of the products as well as decreasing the production cost. With the surface mount technology, the thinning and downsizing of the electronic parts further are advancing. For example, the DIP (dual inline package) which is a package for semiconductor ICs and the PGA (pin grid array) are presently being replaced by the SOP (small outline package) and BGA (ball grid array). As to the discrete semiconductor package as well, the SMD (small mount device) package is becoming the main stream of its technology.

However, with regard to the package of the power device, since it has a simplified SMD structure in which a screw nut portion and an external terminal (pin) of the existing THD (through hole mount device) are simply cut off, and therefore it cannot fully meet the demands of downsizing of the products as well as decreasing the production cost.

As described above, conventionally, in a power device having a high input impedance, such as MOSFET or IGBT, if the operation frequency becomes close to 100 kHz or higher, the improvement of the characteristics of the power device can no longer proceed. Further, in terms of the package of the power device, the development of thin and small-sized package suitable for the surface mount has been conventionally insufficient.

The present invention has been achieved as a solution to the above-described drawbacks, and the object thereof is to provide a power device having a high input impedance, in which even if the operation frequency thereof becomes close to 100 kHz or higher, the improvement of the characteristics of the power device (for example, switching speed) does not peak out, and whose package is suitable for the surface mount.

The power device of the present invention includes: a semiconductor chip on which a switching element is formed; a package for covering the semiconductor chip; a first lead line connected to a control electrode of the switching element, a second lead line connected to the first electrode of the switching element; third and fourth lead lines both connected to the second electrode of the switching element and separated from each other, wherein an input voltage is applied between the first lead line and the third lead line, and an output current is allowed to flow between the second lead line and the fourth lead line.

This summary of the invention does not necessarily describe all necessary features so that the invention may also be a sub-combination of these described features.

The invention can be more fully understood from the following detailed description when taken in conjunction with the accompanying drawings, in which:

FIG. 1 is a diagram showing a conventional power device;
FIG. 2 is a diagram showing a cross section of the power device shown in FIG. 1;
FIG. 3 is a diagram showing a first embodiment of the power device according to the present invention;
FIG. 4 is a diagram showing a cross section of the power device shown in FIG. 3;
FIG. 5 is a diagram showing a second embodiment of the power device according to the present invention;
FIG. 6 is a diagram showing a cross section of the power device shown in FIG. 5;
FIG. 7 is a diagram showing an equivalent circuit to the power device of the present invention;
FIG. 8 is a diagram showing an On-waveform of a conventional product (three-terminal type);
FIG. 9 is a diagram showing an On-waveform of the present invention product (four-terminal type);
FIG. 10 is a diagram showing an Off-waveform of a conventional product (three-terminal type); and
FIG. 11 is a diagram showing an Off-waveform of the present invention product (four-terminal type).

A packaging structure of a power device of the present invention will be described below in detail with reference to the accompanying drawings.

FIG. 3 shows a power device according to the first embodiment of the present invention, and FIG. 4 shows a cross section of the power device shown in FIG. 3.

This embodiment will be described while taking a surface amount type power MOSFET as an example.

Within a semiconductor chip 1, a vertical-type MOSFET (power switching element) is formed, and the rear surface of the semiconductor chip 1 serves as a drain of the vertical-type MOSFET. The rear surface of the semiconductor chip 1 is fixed to a frame heat radiating portion 2-1 with solder or electroconductive resin. The frame heat radiating portion 2-1 has a function of radiating the heat generated in the semiconductor chip 1 to the outside of the package, and further it functions as an external terminal (D) of the drain of the vertical MOSFET.

On a main surface of the semiconductor chip 1, a source electrode 5 and a gate electrode 6 of the vertical-type MOSFET are formed. The source electrode 5 is connected to an external terminal (S1) 2-2-1 of a source of the MOSFET via a bonding wire 3a, as well as to an external terminal (S2) 2-2-2 of the source of the MOSFET via a bonding wire 3c. As mentioned, the external terminals (S1, S2) 2-2-1 and 2-2-2 are both connected to the source electrode 5 of the vertical MOSFET, but they are separated from each other.

A gate electrode 6 is connected to an external terminal (G) 2-3 of a gate of the vertical MOSFET via a bonding wire 3b.

The source external terminal 2-2-1 of the vertical type MOSFET serves as an output terminal for taking out an output current, and the external terminal 2-2-2 serves, together with the external terminal 2-3, as an input terminal for applying an input voltage.

The bonding wires 3a and 3b are made of a metal material such as aluminum (Al) or gold (Au). The semiconductor chip 1 and its peripheral portion are covered by a resin 4. However, portions of four external terminals (G, D, S1 and S2) of the vertical MOSFET are exposed from the resin 4.

The main feature of the above-described power device is that there are two source external terminals of the vertical-type MOSFET. The external terminal (S1) 2-2-1 serves as an output terminal for taking out an output current, and the external terminal (S2) 2-2-2 serves, together with the external terminal 2-3, as an input terminal for applying an input voltage.

Since the external terminal 2-2-1 is a terminal for taking out an output current, the size thereof is set to be as large as possible. Further, the number of bonding wires 3a for connecting the source electrode 5 and the external terminal 2-2-1 is made as large as possible (for example, in plural).

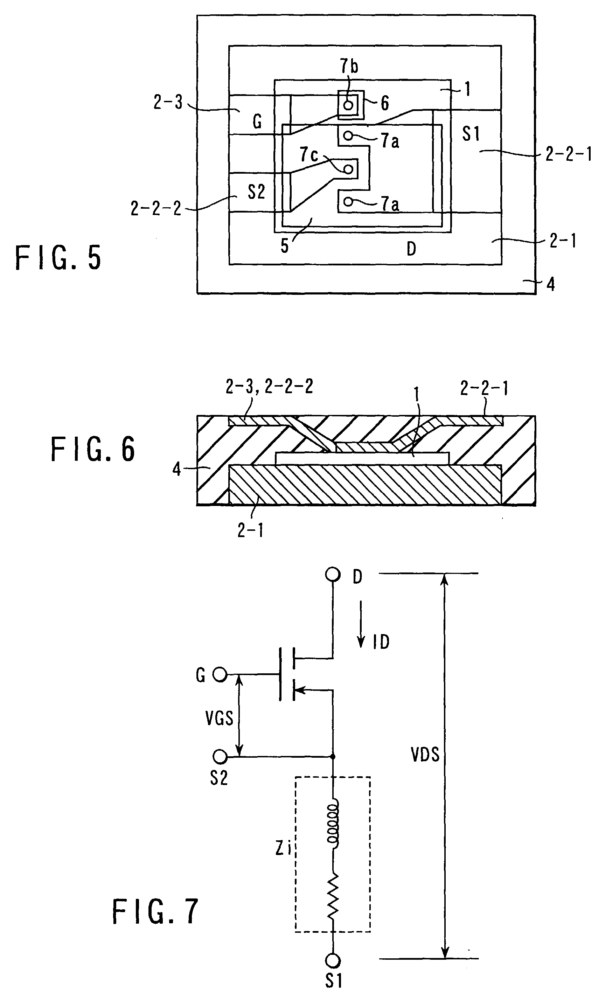

In the meantime, between the source of the vertical-type MOSFET and the external terminal 2-2-1, there are resistance component and inductance component of the internal wiring of the semiconductor chip 1 and the bonding wire 3a. (Zi of FIG. 5)

Therefore, the resistance component and inductance component between the source of the vertical-type MOSFET and the external terminal 2-2-1, are made as small as possible by shortening the internal wiring of the semiconductor chip 1, or increasing the number of bonding wires 3a.

In the meantime, the external terminal 2-2-2, as in the case of the external terminal 2-3, is a terminal for applying an input voltage VGS, and therefore its size may be smaller than that of the external terminal 2-2-1. Further, the number of bonding wires 3c for connecting the source electrode 5 and the external terminal 2-2-2 may be small (for example, one).

In short, the external terminals 2-2-2 and 2-3 are terminals for applying an input voltage VGS, and therefore in particular, the resistance component and inductance component between the source of the vertical-type MOSFET and the external terminal 2-2-2 would not matter.

With the above-described structure employed, the characteristics of the element (for example, switching speed) can be improved. This advantage is remarkable particularly in a device having an allowable power dissipation PD of 100 [W] or higher, or in a device which operates at an operation frequency of close to 100 [kHz] or higher. It should be noted here that the specific effect regarding the switching speed will be explained later.

The above-described power device employs a surface mount type package. Further, since the source external terminal (input terminal) 2-2-2 of the vertical MOSFET and the gate external terminal (input terminal) 2-3 are arranged to be adjacent to each other, the layout of wiring of a board (for example, print circuit board) becomes easy. Consequently, the size of the product (or the system) can be reduced, or the cost can be lowered.

It should be noted that in FIG. 3, the position of the gate external terminal 2-3 and that of the source external terminals 2-2-1 and 2-2-2 may be switched over, on a condition that the source external terminal 2-2-1 and the gate external terminal 2-3 are arranged to be adjacent to each other.

FIG. 5 shows a power device according to the second embodiment of the present invention, and FIG. 6 shoes a cross section of the power device shown in FIG. 5.

This embodiment will be explained taking the surface mount type power MOSFET as an example.

The power device of this embodiment is characterized by an aspect that the device has such a shape which is formed in consideration of the convenience of the mount of the device onto the module device. In other words, the gate external terminal 2-3 and the two source external terminal 2-2-1 and 2-2-2 are arranged on respective surface sides of the package, and the drain external terminal 2-1 is disposed on the other surface side of the package.

The power device of this embodiment will now be described in specific.

In a semiconductor chip 1, a vertical-type MOSFET (power switching element) is formed, and the rear surface of the semiconductor chip 1 serves as a drain of the vertical-type MOSFET. The rear surface of the semiconductor chip 1 is fixed to a frame heat radiating portion 2-1 with solder or electroconductive resin. The frame heat radiating portion 2-1 has a function of radiating the heat generated in the semiconductor chip 1 to the outside of the package, and further it functions as a drain external terminal (D) of the vertical MOSFET.

On a main surface of the semiconductor chip 1, a source electrode 5 and a gate electrode 6 of the vertical-type MOSFET are formed. The source electrode 5 is connected to an external terminal (S1) 2-2-1 of a source of the MOSFET, as well as to an external terminal (S2) 2-2-2 of the source of the MOSFET. As mentioned, the external terminals (S1, S2) 2-2-1 and 2-2-2 are both connected to the source electrode 5 of the vertical MOSFET, but they are separated from each other. A gate electrode 6 is connected to an external terminal (G) 2-3 of a gate of the vertical MOSFET.

The source external terminal 2-2-1 of the vertical type MOSFET serves as an output terminal for taking out an output current, and the external terminal 2-2-2 serves, together with the external terminal 2-3, as an input terminal for applying an input voltage.

The semiconductor chip 1 and its peripheral portion are covered by a resin 4. However, portions of four external terminals (G, D, S1 and S2) of the vertical MOSFET are exposed from the resin 4.

In the above-described power device as well, there are two source external terminals of the vertical-type MOSFET. The external terminal (S1) 2-2-1 serves as an output terminal for taking out an output current, and the external terminal (S2) 2-2-2 serves, together with the external terminal 2-3, as an input terminal for applying an input voltage.

Since the external terminal (S1) 2-2-1 is a terminal for taking out an output current, the size thereof is set to be as large as possible. Further, the number of contacts (bumps 7a) for connecting the source electrode 5 and the external terminal 2-2-1 is made as large as possible.

In the meantime, between the source of the vertical-type MOSFET and the external terminal 2-2-1, there are resistance component and inductance component of the internal wiring of the semiconductor chip 1. (Zi of FIG. 5)

Therefore, the resistance component and inductance component between the source of the vertical-type MOSFET and the external terminal 2-2-1, are made as small as possible by shortening the internal wiring of the semiconductor chip 1.

In the meantime, the external terminal (S2) 2-2-2, as in the case of the external terminal 2-3, is a terminal for applying an input voltage VGS, and therefore its size may be smaller than that of the external terminal 2-2-1. Further, the number of contacts (bumps 7c) for connecting the source electrode 5 and the external terminal 2-2-2 may be small.

In short, the external terminals 2-2-2 and 2-3 are terminals for applying an input voltage VGS, and therefore in particular, the resistance component and inductance component between the source of the vertical-type MOSFET and the external terminal 2-2-2 would not matter.

With the above-described structure employed, the characteristics of the element (for example, switching speed) can be improved. This advantage is remarkable particularly in a device having an allowable power dissipation PD of 100 [W] or higher, or in a device which operates at an operation frequency of close to 100 [kHz] or higher.

In the packaging structure of the above-described power device, bonding wire is not used, and therefore the size of the package can be reduced. Further, the resistance component and inductance component between the source of the vertical-type MOSFET and the external terminal 2-2-1 become lower than those of the power device of the first embodiment described above.

Further, in the packaging structure of the above-described power device, the source external terminal 2-2-2 and the gate external terminal 2-3 of the vertical-type MOSFET are arranged on the same plane to be adjacent to each other, and therefore the wiring layout on a module device side, that is, mount board (for example, print circuit board) can be facilitated.

As described above, the power device of the present invention has such a package structure that can facilitate the mount of the device onto a module device. As a result, the size of the system can be reduced, and the production cost can be decreased.

Next, the advantages achieved when the power device shown in FIGS. 3 to 6 is employed, will now be described.

FIG. 7 shows an equivalent circuit to the power device shown in FIGS. 3 to 6.

VGS denotes a voltage between a gate terminal (external terminal) G and a source terminal (external terminal) S2, VDS denotes a voltage between a drain terminal (external terminal) D and a source terminal (external terminal) S1, and ID denotes a drain current.

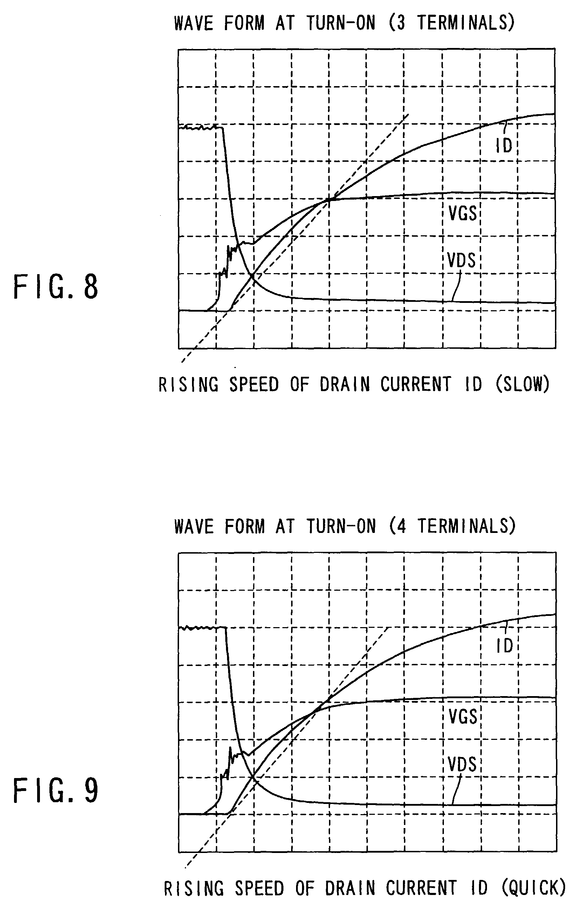

FIG. 8 indicates results of the measurement of the On-waveform, carried out on a conventional product (three-terminal product), and FIG. 9 indicates results of the measurement of the On-waveform, carried out on a present invention product (four-terminal product).

These figures indicate that in terms of the rise of the drain current ID, the present invention product involves a higher speed than that of the conventional product. In short, in the present invention product, the switching speed from an Off state to an On state becomes higher than that of the conventional case.

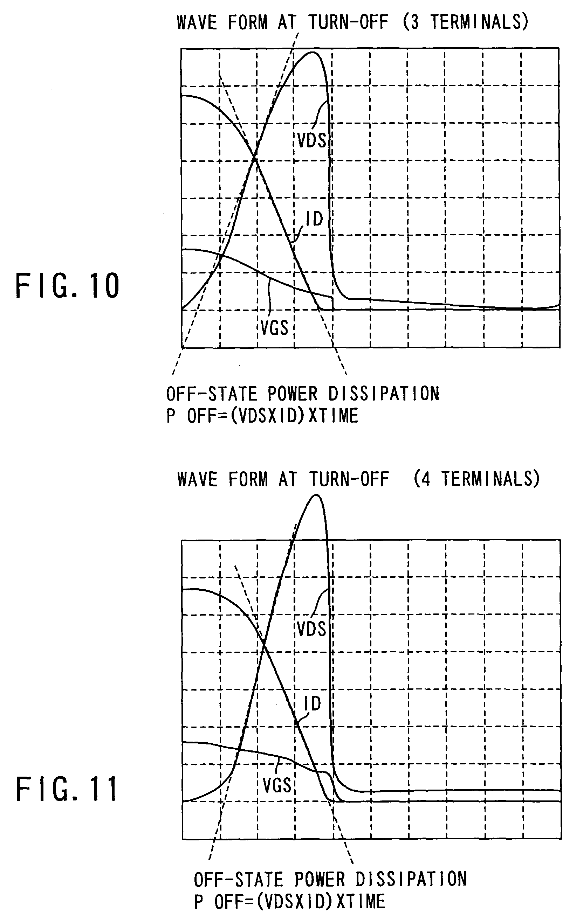

Further, FIG. 10 indicates results of the measurement of the Off-waveform, carried out on the conventional product (three-terminal product), and FIG. 11 indicates results of the measurement of the Off-waveform, carried out on the present invention product (four-terminal product).

These figures indicate that in terms of the fall of the drain current ID, the present invention product involves a higher speed than that of the conventional product. In short, in the present invention product, the switching speed from an On state to an Off state becomes higher than that of the conventional case.

As described above, according to the present invention, the turn-on time and turn-off time are both shortened, and therefore a high-speed switching operation can be achieved. Further, regarding the switching power dissipation, the results of the comparison between the present invention product and the conventional product are summarized in TABLE 1 below. As presented in TABLE 1, the present invention product achieves the suppression of the switching dissipation by 50% or more as compared to the conventional product.

TABLE 1

Switching power dissipation

|  | Psw | 100 kHz | 200 kHz |
|---|---|---|---|
| Product Having 3 terminals (conventional product) | 37.9 $\mu$J | 3.79W | 7.58W |
| Product having 4 terminals (present invention) | 17.0 $\mu$J | 1.70W | 3.40W |

\* Psw = Pon + Poff
   Pon:  On-state power dissipation
   Poff: Off-state power dissipation

Further, according to the present invention, the adverse effect which is caused by the drain current ID onto the gate-source voltage (input voltage) VGS can be eliminated. That is, in the conventional case, there is only one source external terminal, which serves, as in the gate external terminal, as a terminal for applying an input voltage VGS as well as a terminal for taking out an output current (drain current). With this structure, there results a great adverse effect of the drain current ID acting on the gate-source voltage VGS.

By contrast, in the present invention, there are two source external terminals, one serving as an input terminal and the other serving as an output terminal. With this structure, the adverse effect of the drain current ID acting on the gate-source voltage VGS can be significantly reduced, and therefore the noise can be decreased.

Further, the present invention employs a surface mount type package. For example, in the case of such a vertical-type MOSFET as presented above, the contact area between the source terminals S1 and S2 and the print circuit board are remarkably increased, and therefore the generation heat at the external terminals, which occurs when a large current is created, becomes low. Further, since the size of the package is thinned and made small, the size of the overall system can be reduced, and the production cost can be decreased.

As described above, the present invention is directed to a package structure of a power device having a high input impedance, in which the number of source external electrodes of the MOS transistor is set to 2, for example, and therefore with this invention, the characteristics of the element (for example, the switching speed) can be improved. This advantage is significant particularly in a device having an allowable power dissipation $P_D$ of 100W or higher (for example, a vertical-type MOSFET) or a device having an operation frequency of close to 100 kHz or higher. Further, since the present invention employs a surface mount type package, the size of the package can be thinned and reduced.

**Claims**

1.   A power device characterized by comprising:

       a semiconductor chip (1) on which a switching element having a control electrode (6), a first electrode (1) and a second electrode (5) is formed;
       a package (4) for covering the semiconductor chip;
       a first external terminal (2-3) connected to the control element of the switching element;
       a second external terminal (2-1) connected to the first electrode of the switching element; and
       third and fourth external terminals (2-2-1, 2-2-2) connected to the second electrode of the switching element and separated from each other;

wherein an input voltage is applied between the first external terminal (2-3) and the third external terminal (2-2-2), and an output current is allowed to flow between the second external terminal (2-1) and the fourth external terminal (2-2-1).

2. The power device according to claim 1, characterized in that: the first external terminal (2-3) and the third external terminal (2-2-2) are arranged to be adjacent to each other.

3. The power device according to claim 1, characterized in that: the first external terminal (2-3) and the third external terminal (2-2-2) are arranged in a same plane.

4. The power device according to claim 1, characterized in that: the switching element has a high input impedance.

5. The power device according to claim 1, characterized in that: the switching element has an allowable power dissipation of 100W or higher.

6. The power device according to claim 1, characterized in that: the switching element has an operation frequency of 100 kHz or higher.

7. The power device according to claim 1, characterized in that: the switching element is a MOSFET and the second electrode is a source electrode of the MOSFET.

8. The power device according to claim 1, characterized in that: portions of surfaces of the first, second, third and fourth external terminals (2-1, 2-2-1, 2-2-2 and 2-3) are substantially leveled with a surface of the package (4).

9. The power device according to claim 1, characterized in that: the second electrode (5) and the third external terminal (2-2-2) are connected to each other via one bonding wire (3c), and the second electrode (5) and the fourth external terminal (2-2-1) are connected to each other via a plurality of bonding wires (3a).

10. The power device according to claim 1, characterized in that: the second electrode (5) and the third external terminal (2-2-2) are connected to each other via one bump (7c), and the second electrode (5) and the fourth external terminal (2-2-1) are connected to each other via a plurality of bumps (7a).

11. The power device according to claim 1, characterized in that: a resistance and inductance between the second electrode (5) and the fourth external terminal (2-2-1) are smaller than those between the second electrode (5) and the third external terminal (2-2-2).

FIG. 1

G
2-3
S
2-2
3b
6
1
D
5
3a
4
2-1

FIG. 2

3a, 3b
4
1
2-2, 2-3

FIG. 3

G
2-3
S2
2-2-2
S1
2-2-1
3b
6
1
3c
D
5
3a
4
2-1

FIG. 4

3a, 3b, 3c
4
1
2-2-1, 2-2-2, 2-3
2-1

**FIG. 5**

**FIG. 6**

**FIG. 7**

WAVE FORM AT TURN-ON (3 TERMINALS)

FIG. 8

RISING SPEED OF DRAIN CURRENT ID (SLOW)

WAVE FORM AT TURN-ON (4 TERMINALS)

FIG. 9

RISING SPEED OF DRAIN CURRENT ID (QUICK)

WAVE FORM AT TURN-OFF (3 TERMINALS)

**FIG. 10**

OFF-STATE POWER DISSIPATION
P OFF=(VDSXID)XTIME

WAVE FORM AT TURN-OFF (4 TERMINALS)

**FIG. 11**

OFF-STATE POWER DISSIPATION
P OFF=(VDSXID)XTIME